# EUROPEAN PATENT SPECIFICATION

(11) **EP 3 249 072 B1**
(45) Date of publication and mention of the grant of the patent: **31.07.2019**
(21) Application number: 16382228.1
(22) Date of filing: 24.05.2016
(51) Int. Cl.: C23C 14/02, B64D 45/02, C23C 14/14, C23C 14/22

(54) **METHOD FOR INCREASING THE ELECTRICAL CONDUCTIVITY OF A COMPOSITE PART SURFACE**
VERFAHREN ZUR ERHÖHUNG DER ELEKTRISCHEN LEITFÄHIGKEIT EINER VERBUNDTEILOBERFLÄCHE
PROCÉDÉ POUR AUGMENTER LA CONDUCTIVITÉ ÉLECTRIQUE DE LA SURFACE D'UNE PIÈCE COMPOSITE

(43) Date of publication of application: 29.11.2017
(73) Proprietor: Airbus Defence and Space, S.A.U., 28906 Getafe - Madrid (ES)
(72) Inventor: NOGUEROLES VIÑES, Pedro, E-28906 Getafe, Madrid (ES); LÓPEZ ROMANO, Bernardo, E-28906 Getafe, Madrid (ES); SÁNCHEZ VICENTE, Laura, E-28906 Getafe, Madrid (ES); JIMÉNEZ GUERRERO, Ignacio, E-28049 Madrid (ES); CASCALES FERNÁNDEZ, José, E-28049 Madrid (ES); GARCÍA FUENTES, Gonzalo, E-31191 Cordovilla, Navarra (ES); ALMANDOZ SÁNCHEZ, Eluxka, E-31191 Cordovilla, Navarra (ES); BUENO LÓPEZ, Rebeca, E-31191 Cordovilla, Navarra (ES)
(74) Representative: ABG Intellectual Property, S.L.

(56) References cited:
- US-A1- 2009 092 844
- US-A1- 2015 292 074
- FESSMANN ET AL: "Adherent metallization of carbon-fibre-reinforced plastic composites using a combined vacuum/electrochemical deposition process", SURFACE AND COATINGS TECHNOLOGY, ELSEVIER BV, AMSTERDAM, NL, vol. 54-55, 1 January 1992 (1992-01-01), pages 599-603, XP022428427, ISSN: 0257-8972, DOI: 10.1016/S0257-8972(07)80090-9
- GAGNÉ MARTIN ET AL: "Lightning strike protection of composites", PROGRESS IN AEROSPACE SCIENCES, OXFORD, GB, vol. 64, 4 September 2013 (2013-09-04), pages 1-16, XP028812570, ISSN: 0376-0421, DOI: 10.1016/J.PAEROSCI.2013.07.002

## Description

### TECHNICAL FIELD OF THE INVENTION

The present invention is related to the field of manufacturing composite parts. Particularly, it relates to a method for increasing the electrical conductivity of a surface of a composite part.

### BACKGROUND OF THE INVENTION

Composite parts are used in several technical fields, such as aeronautic, naval or railway vehicles and structures or wind turbines. Since the composites have poor electrical conductivity, some operations are required to increase their electrical conductivity.

Several solutions are known for increasing the electrical conductivity of a surface of a composite part. This is the case, for example, for protecting the composite part against lightning strikes.

Currently known methods consist on covering the composite part with a metallic mesh or foil (expanded copper foil, bronze mesh, etc). The main problem associated with these solutions is the weight added to the composite part, especially in the previous mentioned fields where weight saving is of the outmost importance.

Furthermore, these covering operations are usually hand-made, which result in very expensive elements.

Methods for increasing the electrical conductivity of a surface of a composite material part by applying a metal layer by vapour deposition are disclosed in prior art publications "Adherent metallization of carbon-fibre-reinforced plastic composites using a combined vacuum/electrochemical deposition process", Essmann et al., Surface and Coatings Technology, vol. 54-55 (1992), pages 599-603; and "Lightning strike protection of composites", Gagné et al., Progress in Aerospace Sciences, vol. 64 (2014), pages 1-16; as well as US 2015/0292074 A1.

### SUMMARY OF THE INVENTION

The present invention provides a solution for the aforementioned problems by a method according to claim 1. All the features described in this specification, including the claims, description and drawings, can be combined in any combination, with the exception of combinations of such mutually exclusive features.

According to a first inventive aspect, the invention provides a method for increasing the electrical conductivity of a surface of a composite part comprising at least one surface, the method comprising the step of
applying a coating layer comprising a metal, the coating layer thickness being 0.1-10 µm and said coating layer being applied on the at least one surface of the composite part, by means of physical vapour deposition;
wherein the application of the coating layer is made in vacuum conditions.

In the context of the present invention vacuum conditions mean that pressure is lower than 0.1 mbar, preferably between 0.001 mbar and 0.08 mbar.

Physical vapour deposition is referred to any method that comprises the formation of a vapour of the material to be applied as a coating layer by physical means, and the deposition of this vapour on a substrate, which in this case corresponds to the composite part, to form the coating layer. There are some particular examples of physical vapour deposition methods, wherein a coating layer is treated to be deposited on a substrate:
- Thermal evaporation: the coating material contained in a target or crucible is brought to the evaporation or sublimation temperature, by means of a resistive heater or by a high energy electron beam directed towards the coating layer. This is done in a high vacuum, at pressures below 0.1 mbar, both to allow the vapour to reach the substrate without reacting with or scattering against other gas-phase atoms in the chamber, and to reduce the incorporation of impurities from the residual gas in the vacuum chamber.
- Molecular beam epitaxy: this is a particular example of thermal evaporation, wherein slow-flowing streams of vapour of the coating material are directed towards the substrate, so that the coating layer deposits one atomic layer at a time.
- Magnetron sputtering: the coating material is placed in a target and is knocked by a plasma, usually a noble gas such as argon, to pull out a few atoms of this material at a time. The target can be kept at a relatively low temperature, since the process is not one of evaporation. It is especially useful for compounds or mixtures, where different components would otherwise tend to evaporate at different rates. Nitrogen and oxygen gases are also being used in sputtering to produce nitrides and oxides of the target material in the so-called reactive sputtering mode. A particular embodiment of magnetron sputtering is high power impulse magnetron sputtering.• Cathodic arc deposition: an electrical arc literally blasts ions from the cathode of the coating material. The arc has an extremely high power density resulting in a high level of ionization (30-100%), multiply charged ions, neutral particles, clusters and macro-particles (droplets). In particular embodiments, a reactive gas, such as N₂, O₂, H₂, C₂H₂, is introduced during the evaporation process. In these embodiments, dissociation, ionization and excitation can occur during interaction of the reactive gas with the ion flux of the coating layer, the coating material being therefore deposited.• Pulsed laser deposition: pulses of focused laser light vaporize the surface of the coating material and convert it to plasma; this plasma usually reverts to a gas before it reaches the substrate.• Ion beam assisted deposition: it combines the supply of vapour atoms from a evaporation or sputtering source, with the supply of ions emitted by an ion beam, to form a coating layer from the combination of atoms and ions.

Throughout this document, the expression "coating material" will be understood as the material stored in a bulk, and the expression "coating layer" will be understood as the coating material which has been deposited as a layer on the surface of a composite part.

Advantageously, this method outputs a composite part with increased electrical conductivity. Therefore, the composite part obtained can be employed against lightning strike and presents a lighter weight and a better surface finish than the composite parts manufactured by known methods.

As an advantage, this method ensures the manufacturing of a lighter part, by a method which may be automatized and which does not need additional space to keep the meshes prior to be added to the composite parts.

The method according to the invention further comprises a step of preparing the surface of the composite part prior to the application of the coating layer, this step being performed in vacuum conditions.

In a particular embodiment, the step of preparing the surface of the composite part comprises ion beam modification of the surface using at least one gas.

In a particular embodiment, the at least one gas is an inert gas.

In a particular embodiment, the step of preparing the surface of the composite part comprises exposing the surface of the composite part to an ionized gas.

The step of preparing the surface of the composite part comprises applying an intermediate bonding layer by means of physical vapour deposition before the coating layer, wherein the bonding layer comprises a metal nitride, such as TiN and CuN. This bonding layer improves the adherence of the coating layer which applied subsequently.

In a particular embodiment, the coating layer application is applied through cathodic arc deposition and/or magnetron sputtering, and/or thermal evaporation.

In a particular embodiment, between the step of preparing the surface of the composite part and the step of applying the coating layer the vacuum conditions are maintained. In a more particular embodiment, the step of preparing the surface of the composite part and the step of applying the coating layer are separated by a specific period of time.

In a particular embodiment, the coating layer comprises copper and/or aluminium.

In a particular embodiment, the coating layer has a thickness greater than 1 µm, preferably between 1 and 5 µm. Advantageously, this thickness is enough to provide a better electrical conductivity and in particular a lightning strike protection when the coating layer is applied by a method according to the invention. In a more particular embodiment, the coating layer is between 2 and 3.5 µm thick, which has even a better electrical conductivity and a better behaviour for lightning protection without excessive weight.

In a particular embodiment, the at least one surface is submitted to a specific treatment in order to improve the adherence of the subsequent coating layer. More particularly, the at least one surface of a composite part is submitted to a surface preparation treatment in non-vacuum conditions prior to the application of the coating layer, preferably a sandblasting treatment.

In a particular embodiment, in a prior step of the step of preparing the surface of the composite part, the at least one surface of a composite part is submitted to a surface preparation treatment, preferably a sandblasting treatment in non-vacuum conditions. In another particular embodiment, the at least one surface of a composite part comprises a detachable cocured layer. In this particular embodiment, the detachable cocured layer is a layer that can be removed from the composite part before applying the subsequent coating layer. In this context, the term cocured is known as a cured process wherein a cured composite part attached to a detachable layer is cured together. In this embodiment, the detachable cocured layer being removed in non-vacuum conditions prior to the application of the coating layer.

In another particular embodiment, in a prior step of the step of preparing the surface of the composite part, the at least one surface of the composite part comprises a detachable cocured layer, the detachable cocured layer being removed in this prior step in non-vacuum conditions.

Advantageously, theses embodiments improve the roughness of the surface of the composite part, and the subsequent adhesion of the coating layer.

### DESCRIPTION OF THE DRAWINGS

These and other characteristics and advantages of the invention will become clearly understood in view of the detailed description of the invention which becomes apparent from preferred embodiments of the invention, given just as an example and not being limited thereto, with reference to the drawings.
- Figure 1:: This figure shows a composite part without performing the method of the invention.
- Figure 2:: This figure shows a scheme of a first step of a particular embodiment of the method of the invention.
- Figure 3:: This figure shows a composite part that has undergone the first step of the same particular embodiment of the method according to the present invention.
- Figure 4:: This figure shows a scheme of a second step of a particular embodiment of the method of the invention.
- Figure 5:: This figure shows a composite part that has undergone the second step of a particular embodiment of the method according to the invention.
- Figure 6:: This figure shows a section view of the composite part after performing a particular embodiment of the method according to the invention.
- Figure 7:: This figure shows an aircraft with a composite part treated according to the method of the present invention.

### DETAILED DESCRIPTION OF THE INVENTION

Once the object of the invention has been outlined, specific non-limitative embodiments are described hereinafter.

In a preferred embodiment of the invention, the method comprises two steps: a first step of preparing of the surface (2) of the composite part (1), and a second step of applying a coating layer comprising aluminium. Both steps are performed under vacuum conditions.

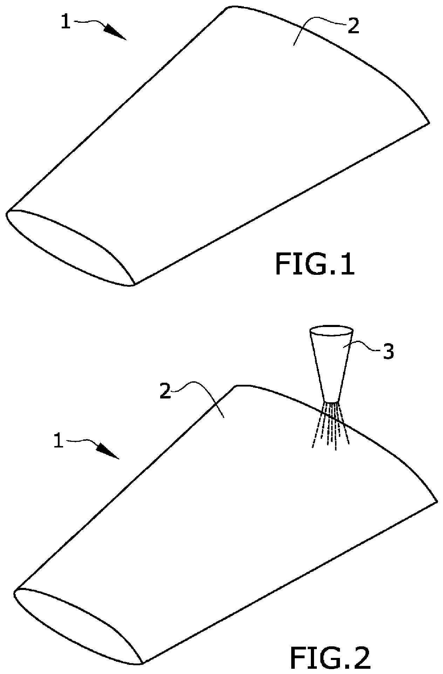

Figure 1 shows a surface (2) of a raw composite part (1) that will be treated with the method of this embodiment for increasing the electrical conductivity of such surface. In this particular figure, this composite part (1) is a part of a horizontal stabilizer of an aircraft (9), but the method of the invention can be applied to any other composite part employed in an aircraft or any vehicle.

Figure 2 shows an example of the first step of the method, wherein the surface (2) of the composite part (1) is treated by using ion-beam modification (3) with an inert gas. In a particular embodiment the inert gas is Nitrogen. The first step of the method improves the adhesion of the coating layer to be applied in the second step.

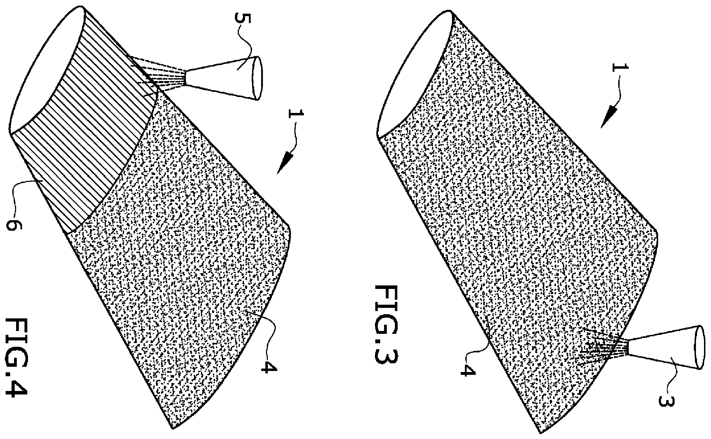

Once the ion-beam modification (3) has been applied, the surface (2) of the composite part (1) becomes a prepared surface (4) which is ready for the second step, as it is shown in Figure 3.

In an alternative embodiment, the surface (2) of the composite part (1) comprises a detachable cocured layer. The detachable cocured layer is removed in non-vacuum condition and prior to the step of preparing the surface (2) of the composite part (1) shown in figure 2.

Figure 4 shows an example of the second step of the method, wherein a coating layer (6) is applied by physical vapour deposition (5) on the prepared surface (4). In a preferred embodiment, the time elapsed after the first step has been performed is of 30 seconds or less. In this particular embodiment, the physical vapour deposition (5) is applied through a cathodic arc deposition and/or magnetron sputtering, and/or thermal evaporation.

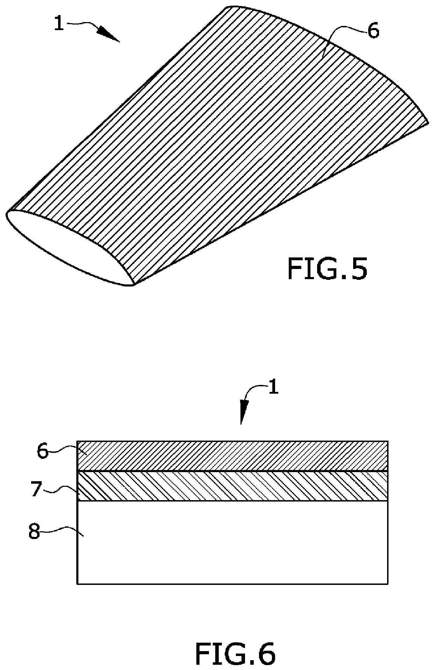

Once the physical vapour deposition (5) has been applied, the surface (2) of the composite part (1) comprises the coating layer (6) as it is shown in Figure 5. Advantageously, the electric conductivity of the treated surface (2) of the composite part (1) has been increased, thus solving the problems stated in the state of the art.

Optionally, the composite part (1) is then painted or undergoes any other suitable treatment that leaves it in condition for use in a suitable structure, such as an aircraft.

Figure 6 shows a section view of the distribution of layers of the composite part (1) after applying a method of the invention according to a further embodiment.

In said embodiment the coating layer (6) comprises copper with a thickness of 3 µm and during the first step of the method an intermediate bonding layer (7) of TiN and CuN it is applied by means of physical vapour deposition. Once the method of this embodiment has been performed, the composite part (1) comprises a composite part core (8), the bonding layer (7) and the coating layer (6).

In an alternative embodiment, the surface (2) of the composite part (1) is submitted to a sandblasting treatment. The sandblasting treatment is applied in non-vacuum condition and prior to the step of preparing the surface (2) of the composite part (1).

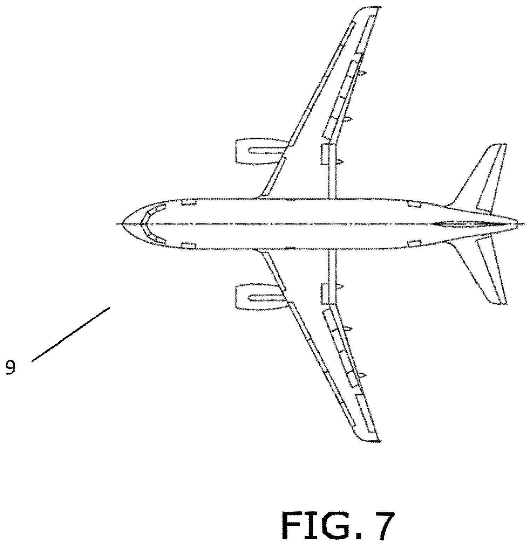

In Figure 7 it is shown an example of an aircraft (9) which comprises at least one composite part (1) wherein its surface has been treated by the method for increasing the electric conductivity of the present invention.

## Claims

1. Method for increasing the electrical conductivity of a surface of a composite material part (1) suitable for an aircraft, the composite material part (1) comprising at least one surface (2), the method comprising the step of
applying a metallic material coating layer (6), the coating layer thickness being 0.1-10 µm and said coating layer (6) being applied on the at least one surface (2) of the composite material part (1), by means of physical vapour deposition (5);
wherein the application of the coating layer (6) is made in vacuum conditions, **characterized in that**
the method further comprises a step of preparing the surface (2) of the composite material part (1) prior to the application of the coating layer (6), this step being performed in vacuum conditions, and comprising applying an intermediate bonding layer (7) by means of physical vapour deposition (5) before the coating layer (6) and wherein the bonding layer (7) comprises a metal nitride.

2. Method according to claim 1, wherein the coating layer (6) application is applied through cathodic arc deposition and/or magnetron sputtering, and/or thermal evaporation.

3. Method according to any of preceding claims, wherein the coating layer (6) comprises copper and/or aluminium.

4. Method according to any of preceding claims, wherein the coating layer (6) thickness is between 1 and 5 µm.

5. Method according to any of preceding claims, wherein the coating layer (6) thickness is between 2 and 3.5 µm.

6. Method according to any of claims 2 to 5, wherein in a prior step of the step of preparing the surface (2) of the composite material part (1),
- the at least one surface (2) of a composite material part (1) is submitted to a surface preparation treatment, preferably a sandblasting treatment in non-vacuum conditions or
- the at least one surface (2) of the composite material part (1) comprises a detachable cocured layer wherein the detachable cocured layer is removed in this prior step in non-vacuum conditions.

## Patentansprüche

1. Verfahren zur Erhöhung der elektrischen Leitfähigkeit einer Oberfläche eines Verbundmaterialteils (1), das für ein Flugzeug geeignet ist, wobei das Verbundmaterialteil (1) zumindest eine Oberfläche (2) aufweist, wobei das Verfahren den folgenden Schritt umfasst:
Aufbringen einer Metallmaterial-Beschichtung (6), wobei die Beschichtungsdicke 0,1 bis 10 µm beträgt und diese Beschichtung (6) vermittels physikalischer Dampfphasenabscheidung (5) auf der zumindest einen Oberfläche (2) des Verbundmaterialteils (1) aufgebracht wird;
wobei die Aufbringung der Beschichtung (6) unter Vakuumbedingungen erfolgt,
**dadurch gekennzeichnet, dass**
das Verfahren ferner einen Schritt zur Präparierung der Oberfläche (2) des Verbundmaterialteils (1) vor der Aufbringung der Beschichtung (6) umfasst, wobei dieser Schritt unter Vakuumbedingungen erfolgt, und das Aufbringen einer Zwischen-Bond-Schicht (7) vermittels physikalischer Dampfphasenabscheidung (5) vor der Beschichtung (6) umfasst, und wobei die Bond-Schicht (7) ein Metallnitrid aufweist.

2. Verfahren nach Anspruch 1, wobei die Aufbringung der Beschichtung (6) durch kathodische Lichtbogenabscheidung und/oder Magnetron-Sputtern und/oder thermisches Verdampfen erfolgt.

3. Verfahren nach einem der vorstehenden Ansprüche, wobei die Beschichtung (6) Kupfer und/oder Aluminium umfasst.

4. Verfahren nach einem der vorstehenden Ansprüche, wobei die Dicke der Beschichtung (6) zwischen 1 und 5 µm beträgt.

5. Verfahren nach einem der vorstehenden Ansprüche, wobei die Dicke der Beschichtung (6) zwischen 2 und 3,5 µm beträgt.

6. Verfahren nach einem der Ansprüche 2 bis 5, wobei in einem Schritt vor dem Schritt zur Präparierung der Oberfläche (2) des Verbundmaterialteils (1)
- die zumindest eine Oberfläche (2) eines Verbundmaterialteils (1) einer Oberflächenpräparierungsbehandlung, bevorzugt einer Sandstrahlbehandlung unter Nicht-Vakuumbedingungen unterzogen wird, oder
- die zumindest eine Oberfläche (2) des Verbundmaterialteils (1) eine ablösbare co-gehärtete Schicht aufweist, wobei die ablösbare co-gehärtete Schicht in diesem vorherigen Schritt unter Nicht-Vakuumbedingungen entfernt wird.

## Revendications

1. Procédé pour augmenter la conductivité électrique d'une surface d'une pièce (1) en matériau composite, appropriée pour un avion, la pièce (1) en matériau composite comprenant au moins une surface (2), le procédé comprenant l'étape consistant à
appliquer une couche de revêtement (6) en matériau métallique, l'épaisseur de la couche de revêtement étant de 0,1 à 10 µm et ladite couche de revêtement (6) étant appliquée sur au moins une surface (2) de la pièce (1) en matériau composite, par un dépôt physique (5) en phase vapeur ;
dans lequel l'application de la couche de revêtement (6) étant effectuée dans des conditions de vide,
**caractérisé en ce que**
le procédé comprend en outre une étape de préparation de la surface (2) de la pièce (1) en matériau composite avant l'application de la couche de revêtement (6), cette étape étant effectuée dans des conditions de vide, et comprenant le fait d'appliquer une couche intermédiaire de liaison (7) par dépôt physique (5) avant la couche de revêtement (6) et la couche de liaison (7) comprenant un nitrure métallique.

2. Procédé selon la revendication 1, dans lequel l'application de la couche de revêtement (6) s'effectue par dépôt à l'arc cathodique et/ou pulvérisation magnétron, et/ou évaporation thermique.

3. Procédé selon l'une quelconque des revendications précédentes, dans lequel la couche de revêtement (6) comprend du cuivre et/ou de l'aluminium.

4. Procédé selon l'une quelconque des revendications précédentes, dans lequel l'épaisseur de la couche de revêtement (6) est comprise entre 1 et 5 µm.

5. Procédé selon l'une quelconque des revendications précédentes, dans lequel l'épaisseur de la couche de revêtement (6) est comprise entre 2 et 3,5 µm.

6. Procédé selon l'une quelconque des revendications 2 à 5, dans lequel, dans une étape préalable de l'étape de préparation de la surface (2) de la pièce (1) en matériau composite,
- ladite au moins une surface (2) d'une pièce (1) en matériau composite est soumise à un traitement de préparation de surface, de préférence un traitement par sablage sous des conditions autres que de vide, ou
- ladite au moins une surface (2) de la pièce (1) en matériau composite comprend une couche co-durcie apte à être enlevée, la couche co-durcie apte à être enlevée étant enlevée dans cette étape préalable sous des conditions autres que de vide.
